# EUROPEAN PATENT SPECIFICATION

(11) **EP 2 461 356 B1**
(45) Date of publication and mention of the grant of the patent: **15.01.2020**
(21) Application number: 11009285.5
(22) Date of filing: 23.11.2011
(51) Int. Cl.: H01L 21/56, H01L 23/00, H01L 23/29, C08L 33/20, C08L 63/00, C08L 83/04, C08L 83/06, C08G 77/14, C08G 77/455, C08L 83/10

(54) **Wafer mold material and method for manufacturing semiconductor apparatus**
Waferformmaterial und Verfahren zur Herstellung einer Halbleitervorrichtung
Matériau de moule pour plaquettes et procédé de fabrication de l'appareil semi-conducteur

(30) Priority: 03.12.2010 JP 2010270027
(43) Date of publication of application: 06.06.2012
(73) Proprietor: Shin-Etsu Chemical Co., Ltd., Tokyo (JP)
(72) Inventor: Sugo, Michihiro, Annaka-shi Gunma-ken (JP); Kondo, Kazunori, Annaka-shi Gunma-ken (JP); Kato, Hideto, Annaka-shi Gunma-ken (JP)
(74) Representative: Wibbelmann, Jobst

(56) References cited:
- EP-A1- 1 777 278
- EP-A1- 2 280 044
- WO-A1-2010/106780
- DE-A1-102007 032 636
- JP-A- 61 024 258
- JP-A- 2009 283 927
- US-A1- 2001 033 016
- US-A1- 2007 098 995
- US-A1- 2009 160 071
- US-A1- 2010 252 940

## Description

### BACKGROUND OF THE INVENTION

### 1. Field of the Invention

The present invention relates to a wafer mold material, and more particularly to a mold material for collectively molding a wafer having semiconductor devices on a surface thereof by using a resin, and also relates to a method for manufacturing a semiconductor apparatus.

### 2. Description of the Related Art

An increase in diameter and a reduction in thickness are advancing in recent wafer sizes, and a technology for sealing a wafer having semiconductor devices on a surface thereof on the level of wafer are demanded in terms of simplification of a manufacturing process and a reduction in cost. Therefore, besides a conventional transfer molding method using a solid-type epoxy resin, a compression molding method using a liquid-type epoxy resin has been suggested (WO 2009/142065). However, since the resin is flowed in a narrow portion in the transfer molding, there is concern of occurrence of wire transformation, and a problem that a short shot involved by an increase in sealing area is apt to occur arises. Further, the compression molding method has a problem that fine control in the molding range on an end face portion of a wafer is difficult and optimizing flowability and physical properties when flowing a liquid sealing resin into a making machine is not easy.

In regard to this problem, a hardening adhesive sheet has been suggested for protection of a chip surface of a wafer level chip size package and sealing of a metal post (Japanese Unexamined Patent Application Publication No. 2004-161886). When such a hardening adhesive sheet is used, the above-described problem does not occur since a resin does not have to be inpoured. However, warp of a wafer after molding, which has not been recognized as a problem, has become an issue due to an increase in diameter and a reduction in thickness in a recent wafer size, and excellent transference performance is demanded in the hardening adhesive sheet with respect to a thin-film wafer having a large diameter. In this regard, an epoxy resin with large hardening shrinkage is used for the hardening adhesive sheet, and the warp and the transference performance do not become a problem in a wafer having a thickness of 300 µm and a diameter of 200 mm (8 inches), but there is a problem that the warp cannot be ignored in a wafer having a larger size. Therefore, a wafer mold material that has the excellent transference performance with respect to a large-diameter thin-film wafer having, e.g., a diameter of 200 mm (8 inches) or a diameter of 300 mm (12 inches) and can suppress the warp of a wafer after molding has been demanded.

US 2001/033016 A1, EP 2 280 044 A1, JP 61 024258 A, US 2009/160071 A1, US 2010/252940 A1, DE 10 2007 032636 A1, WO 2010/106780 A1, EP 1 777 278 A1, JP 2009 283927 A and US 2007/098995 A1 present other wafer mold materials and wafer molding methods.

### SUMMARY OF THE INVENTION

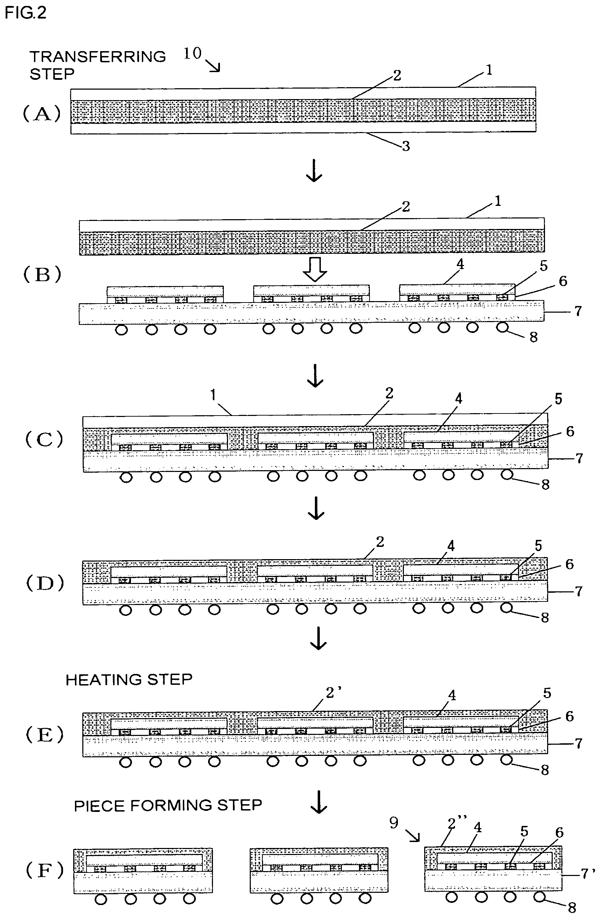

Figure 2 shows an embodiments of the invention. The scope of protection is defined by the claims.

In view of the above-described problem, it is an object of the present invention to provide a wafer mold material that is of a film type instead of a liquid type, enables collective molding (wafer molding) with respect to a wafer having semiconductor devices formed thereon, has excellent transference performance with respect to a large-diameter thin-film wafer, can provide a flexible hardened material with low-stress properties, and can be preferably used as a mold material in a wafer level package with less warp of a formed (molded) wafer, and to also provide a method for manufacturing a semiconductor apparatus using this material.

To achieve this object, according to the present invention, there is provided a wafer mold material for collectively subjecting a wafer having semiconductor devices on a surface thereof to resin molding, wherein the wafer mold material has a resin layer containing a filler and at least any one of an acrylic resin, a silicone resin having an epoxy group, an urethane resin, and a polyimide silicone resin, and the wafer mold material is formed into a film-like shape.

As described above, the wafer mold material that is used for collectively molding a wafer having semiconductor devices on a surface thereof with a resin, has the resin layer containing the filler and at least any one of the acrylic resin, the silicone resin having the epoxy group, the urethane resin, and the polyimide silicon resin, and is formed into a film-like shape can be a wafer mold material that has excellent transference performance with respect to a large-diameter thin-film wafer, can provide a flexible hardened material with low-stress properties, and can be preferably used as a mold material in a wafer level package with less warp of a molded wafer.

Further, it is preferable for the wafer mold material to have a configuration that a film thickness of the resin layer is 20 microns to 500 microns.

As described above, the wafer mold material in which the resin layer has the film thickness of 20 microns to 500 microns can be a wafer mold material that has a film thickness with more excellent transference performance and can further suppress warp of a molded wafer since the thickness is not too large, which is desirable.

Furthermore, it is preferable for the wafer mold material having a configuration that the resin layer is formed on a support film, and a protective film is provided on the resin layer.

In actual use, when there is provided the wafer mold material having the configuration that the resin layer is formed on the support film and the protective film is formed on the resin layer as described above, this material is easy to use, which is desirable.

Moreover, it is preferable for the wafer mold material to have a configuration that a storage elastic modulus of the resin layer at 25°C after hardening is not greater than 1 GPa.

As described above, the wafer mold material having the configuration that the storage elastic modulus of the hardened resin layer at 25°C is not greater than 1 GPa can be a wafer mold material that can provide a flexible hardened material with low-stress properties and has less warp of a molded wafer, which is preferable.

According to the present invention, there is provided a method for manufacturing a semiconductor apparatus comprising at least: a transferring step of transferring the film-like wafer mold material according to any one of claims 1 to 4 onto a wafer having semiconductor devices on a surface thereof; a heating step of heating the transferred wafer mold material; and a piece forming step of cutting the wafer together with the wafer mold material into each piece, the wafer having semiconductor devices on the surface thereof having the heated wafer mold material.

As described above, according to the method for manufacturing a semiconductor apparatus comprising: the transferring step of transferring the film-like wafer mold material onto the wafer having the semiconductor device on the surface thereof; the heating step of heating the transferred wafer mold material; and a piece forming step of cutting the wafer together with the wafer mold material into each piece, the wafer having the semiconductor device on the surface with the heated wafer mold material, since the wafer mold material can be excellently transferred with respect to a large-diameter thin-film wafer in a wafer level package and the wafer mold material can provide a flexible hardened material with low-stress properties, warp of a molded wafer can be suppressed after the heating step, and each piece of the wafer suppressed from warping can be formed, thereby providing the method that can manufacture a semiconductor apparatus having uniform quality.

As described above, according to the present invention, it is possible to provide the wafer mold material that is of the film type instead of the liquid type, enables collective molding (wafer molding) with respect to a wafer having semiconductor devices thereon, has excellent transference performance with respect to a large-diameter thin-film wafer, can provide a flexible hardened material with low-stress properties, and can be preferably used as a mold material in a wafer level package with less warp of a molded wafer, and also provide the method for manufacturing a semiconductor apparatus using this material.

### BRIEF DESCRIPTION OF THE DRAWINGS

FIG. 1 is a cross-sectional view showing an embodiment of a wafer mold material according to the present invention; and
FIG. 2 is flow diagrams of a method for manufacturing a semiconductor apparatus using the wafer mold material according to the present invention.

### DETAILED DESCRIPTION OF THE PREFERRED EMBODIMENTS

A wafer mold material and a method for manufacturing a semiconductor apparatus using this material according to the present invention will now be described hereinafter in detail, but the present invention is not restricted thereto.

As described above, there have been demanded a wafer mold material that has excellent transference performance with respect to a large-diameter thin-film wafer and can provide a flexible hardened material having low-stress properties with less warp of a molded wafer and a method for manufacturing a semiconductor apparatus using this material.

As a result of repeatedly conducting keen examinations to achieve the object, the present inventors have found out that a wafer mold material that is used for collectively molding a wafer having semiconductor devices on a surface thereof with a resin, has a resin layer consisting of at least any one of an acrylic resin, a silicone resin having an epoxy group, an urethane resin, and a polyimide silicone resin and a filler, and is formed into a film-like shape can have excellent transference performance with respect to a large-diameter thin-film wafer, that this material can provide a flexible hardened material with low-stress properties, and that this material can be a wafer mold material with less warp of a molded wafer, thereby bringing the present invention to completion.

Moreover, the present inventors have discovered that a method for manufacturing a semiconductor apparatus using the wafer mold material can suppress a short shot involved by an increase in a sealing area since the film-like mold material is used and can excellently transfer the wafer mold material with respect to a large-diameter thin-film wafer and the wafer mold material can provide a flexible hardened material having low-stress properties, that warp of a molded wafer is thereby reduced, and that an adsorption failure when carrying a molded wafer can be suppressed, and that a method for manufacturing a semiconductor apparatus can avoid displacement of, e.g., a cut position when forming each piece, thereby bringing the present invention to completion. The present invention will now be described hereinafter in detail.

To achieve this object, in the present invention, there is provided a wafer mold material for collectively molding a wafer having semiconductor devices on a surface thereof with a resin,
wherein the wafer mold material has a resin layer containing a filler and at least one of an acrylic resin, a silicone resin having an epoxy group, an urethane resin, and a polyimide silicon resin, and the wafer mold material is formed into a film-like shape.

### [Resin Layer]

The wafer mold material formed into a film-like shape according to the present invention has the resin layer containing the filler and at least any one of the acrylic resin, the silicone resin having the epoxy group, the urethane resin, and the polyimide silicone resin.

As a film thickness of the resin layer, a film thickness of 20 microns to 500 microns is preferable, that of 20 microns to 400 microns is more preferable, and that of 20 microns to 300 microns is particularly preferable. When the film thickness is 20 microns to 500 microns, the film thickness with excellent transference performance can be provided, and the wafer mold material that can further suppress warp of a substrate can be preferably obtained after molding since the film thickness is not too large. Therefore, even if a diameter is increased (8 inches, 12 inches, or above) and a film thickness is reduced in a wafer size, the warp of the wafer after molding can be further suppressed, and more excellent transference performance can be exercised with respect to the wafer, which is preferable.

Additionally, the film-like wafer mold material according to the present invention can have a support film and a protective film. It is preferable to provide a configuration that the resin layer is formed on the support film and the protective film is provided on the resin layer. In actual use, the wafer mold material including the support film and the protective film in this manner is convenient, which is preferable.

Further, as a storage elastic modulus of the resin layer at 25°C after hardening, 1 GPa or below is preferable, and 700 MPa or below is more preferable, and 400 MPa or below is particularly preferable. When the storage elastic modulus is not greater than 1 GPa, a flexible hardened material having low-stress properties can be provided, and the wafer mold material with less warp of a wafer after molding can be obtained, which is preferable. Therefore, even if a diameter is increased (8 inches, 12 inches, or above) and a film thickness is reduced in a wafer size, the warp of the wafer after molding can be further suppressed, which is preferable. Components constituting the resin layer will now be described hereinafter.

### [Acrylic Resin]

Although the acrylic resin according to the present invention is not restricted in particular, an acrylic polymer obtained by copolymerizing three components, i.e., (a) acrylic acid ester and/or methacrylic acid ester, (b) acrylonitrile and/or methacrylonitrile, and (c) unsaturated carboxylic acid is preferable. It is to be noted that this acrylic polymer may be a copolymer containing the components (a) to (c) alone or a copolymer containing any other components. The component (a) is exemplified using the following general formula (1), wherein R¹ represents a monovalent hydrocarbon group.

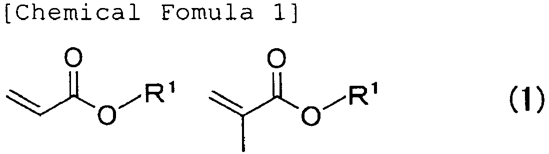

The acrylic acid ester and/or the methacrylic acid ester as the component (a) represented by the general formula (1) gives flexibility to the acrylic polymer, and specific compounds of the acrylic acid ester are, e.g., methyl (meth)acrylate, ethyl (meth)acrylate, n-butyl (meth)acrylate, isobutyl (meth)acrylate, isopentyl (meth)acrylate, n-hexyl (meth)acrylate, isooctyl (meth)acrylate, 2-ethylhexyl (meth)acrylate, n-octyl (meth)acrylate, isononyl (meth)acrylate, n-decyl (meth)acrylate, isodecyl (meth)acrylate, and others. Among other, alkylester (meth)acrylate that R¹ represents an alkyl group whose number of carbon atoms is 1 to 12 or especially 1 to 4 is preferable. One type of (meth)acrylate ester as the component (a) may be used alone, or two or more types of (meth)acrylate ester may be used at the same time.

The unsaturated carboxylic acid as the component (c) gives adhesion properties and serves as a crosslinking point when heated, a copolymerizable vinyl monomer having a carboxyl group can suffice, and specific compounds are, e.g., an acrylic acid, a methacrylic acid, a crotonic acid, a maleic acid, a fumaric acid, an itaconic acid, and others.

When a radial initiator such as a peroxide is used for a mixture of the components (a) to (c), the acrylic polymer can be synthesized. Although an initiator of radical polymerization is not restricted in particular, its examples are 2,2'-azobisisobutyronitrile, 2,2'-azobis(2,4-dimethylvaleronitril), dimethyl 2,2-azobis(2-methylpropionate), benzoyl peroxide, lauroyl peroxide, and the like. As a synthetic method, a known polymerization method can be used.

The film-like wafer mold material having the resin layer containing at least the acrylic resin and the filler can be a wafer mold material that enables collective molding (wafer molding) with respect to a wafer having semiconductor devices, has excellent transference performance even if a diameter is increased (8 inches, 12 inches, or above) and a film thickness is reduced in a wafer size, can provide a flexible hardened material having low-stress properties, and can be preferably used as a mold material in a wafer level package with less warp of a wafer after forming (after molding).

### [Silicone Resin having Epoxy Group]

Although the silicon resin having an epoxy group according to the present invention is not particularly restricted to, e.g., a linear shape, an annular shape, or a branched shape as long as it is a silicone compound having an epoxy group, an example of preferred use is an annular silicone compound having an epoxy group, and another preferred example is a silicone resin having an epoxy group that can be obtained by hydrosilylation using a chloroplatinic acid containing organohydrogenpolysiloxane and polysiloxane containing an alkenyl group. At this time, a silicone resin may be added.

When the film-like wafer mold material having the resin layer containing the silicone resin having the epoxy group and the filler is used, a wafer having semiconductor devices formed thereon can be collectively molded (wafer molding), the excellent transference performance can be obtained even though a diameter is increased and (8 inches, 12 inches, or above) and a film thickness is reduced in a wafer size, a flexible hardened material having low-stress properties can be provided, and this material can serve as a wafer mold material preferably used as a mold material in a wafer level package with less warp of a wafer after shaping (after molding).

### [Urethane Resin]

Although the urethane resin according to the present invention is not restricted in particular, an example of preferred use is an urethane resin synthetically made from an organic diisocyanate compound and a starting material expressed by the following general formula (2). R² represents the same or different types of alkyl groups or aryl groups having carbon numbers 1 to 7, and they are preferably a methyl group, an ethyl group, a propyl group, a phenyl group, a 4-methylphenyl group, and others. Further, X represents a hydrogen group or an amino group. Branched diol or diamine represented by the following general formula (2) functions as a chain length extender in unrethane resin synthesis, wherein R² represents the same or different types of alkyl groups or aryl groups having carbon numbers 1 to 7, and X represents a hydrogen group or an amino group.

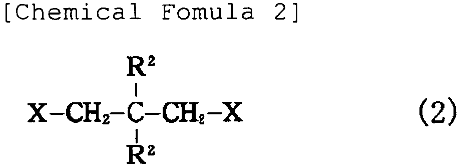

The organic diisocyanate compound is exemplified by 2,4-tolylene diisocyanate, 2,6- tolylene diisocyanate, m-phenylene diisocyanate, p-phenylene diisocyanate, 4,4'-diphenylmethane diisocyanate, 2,4'-diphenylmethane diisocyanate, 2,2'-diphenylmethane diisocyanate, 3,3'-dimethyl-4,4'-biphenylene diisocyanate, 3-3'-dimethoxy-4,4'-biphenylene diisocyanate, 3,3'-dichloro-4,4'-biphenylene diisocyanate, 1,5-naphthalene diisocyanate, 1,5-tetrahydro naphthalene diisocyanate, tetramethylene diisocyanate, 1,6-hexamethylene diisocyanate, dodecamethylene diisocyanate, trimethyl hexamethylene diisocyanate, 1,3-cyclohexylene diisocyanate, 1,4-cyclohexylene diisocyanate, xylylene diisocyanate, tetramethyl xylylene diisocyanate, hydrogenated xylylene diisocyanate, lysine diisocyanate, isophorone diisocyanate, 4,4'-dicyclohexyl methane diisocyanate, 3,3'-dimethyl-4,4'-dicyclohexyl methane diisocyanate, and others.

It is preferable for a ratio of the chain length extender and the organic diisocyanate compound when the chain length extender represented by the general formula (2) and the organic diisocyanate compound are reacted to synthesize the urethane resin to be 1:1 as an equivalent ratio.

When the film-like wafer mold material having the resin layer containing at least the urethane resin and the filler is used, a wafer having semiconductor devices formed thereon can be collectively molded (wafer molding), excellent transference performance can be obtained even though a diameter is increased (8 inches, 12 inches, or above) and a thickness is reduced in a wafer size, a flexible hardened material having low-stress properties can be provided, and this mold material can be a wafer mold material that can be preferably used as a mold material in a wafer level package with less warp of a wafer after shaping (after molding).

### [Polyimide Silicone Resin]

Although the polyimide silicone resin according to the present invention is not restricted in particular, an example of preferred use is a polyimide silicon resin that can be obtained by synthetically making a polyamic acid from dianhydride and a diamine silicone compound such as diaminopolysiloxane and then performing thermal dehydration.

The dianhydride used for synthesis of the polyamic acid can be exemplified by 3,3' and 4,4'-diphenyl sulfone tetracarboxylic dianhydrides, 3,3' and 4,4'-biphenyl tetracarboxylic dianhydrides, 2,3' and 3,4'-biphenyl tetracarboxylic dianhydrides, 5-(2,5-dioxotetrahydro-3-furanyl)-3-methyl-3-cyclohexene-1,2-dicarboxylic anhydride, 4-(2,5-dioxotetrahydrofuran-3-yl)-1,2,3,4-tetrahydronaphthalene-1,2-dicarboxylic anhydride, 1,2,3,4-butane tetracarboxylic dianhydride, 3,3' and 4,4'-benzophenone tetracarboxylic dianhydrides, 4,4'-hexafluoropropylidene bisphthalate dianhydride, 1,3-tetramethyl disiloxane bisphthalate dianhydride, 4,4'-oxydiphthalic dianhydride, and others.

When the film-like wafer mold material having the resin layer containing at least the polyimide silicon resin and the filler is used, a wafer having semiconductor devices formed thereon can be collectively molded (wafer molding), excellent transference performance can be obtained even though a diameter is increased (8 inches, 12 inches, or above) and a film thickness is reduced in a wafer size, a flexible hardened material having low-stress properties can be provided, and this material can serve as a wafer mold material that can be preferably used as a mold material in a wafer level package with less warp of a wafer after shaping (after molding).

### [Filler]

Although the filler according to the present invention is not restricted in particular, examples of preferred use are a silica fine powder, composite silicone rubber fine particles, silicone fine particles, acrylic fine particles, and others, and one type of known material may be solely used, or two types or more of known materials may be combined and used. Furthermore, carbon functional silane may be added for the purpose of improving adhesion to a semiconductor device, a wafer, and others.

As the silica fine powder, there are, e.g., reinforcing silica such as fumed silica or precipitated silica, and crystalline silica such as quartz. Specifically, the silica fine powder is exemplified by Aerosil R972, R974, and R976 manufactured by Nippon Aerosil Co., Ltd., SE-2050, SC-2050, SE-1050, SO-E1, SO-C1, SO-E2, SO-C2, SO-E3, SO-C3, SO-E5, and SO-C5 manufactured by Admatechs Co., Ltd., and Musil120A and Musil130A manufactured by Shin-Etsu Chemical Co., Ltd.

As the composite silicone rubber fine particles, for example, KMP-600, KMP-605, and X-52-7030 manufactured by Shin-Etsu Chemical Co., Ltd., and others can be used.

As the silicone fine particles, for example, KMP-590 and KMP-701 manufactured by Shin-Etsu Chemical Co., Ltd., and others can be used. Moreover, there are fine particles having an average particle diameter of 0.1 to 10 µm. An excessive increase in viscosity can be suppressed if the average particle diameter is not lower than 0.1 µm, and an inferior surface state after sealing can be suppressed when the average particle diameter is not greater than 10 µm, which is preferable.

As the acrylic fine particles, for example, Art-pearl G-800 and SE-006 manufactured by Negami Chemical Industrial Co., Ltd. and others can be used. Further, fine particles having an average particle diameter of 0.1 to 60 µm can be also used. An excessive increase in viscosity can be suppressed when the average particle diameter is not lower than 0.1 µm, and an inferior surface state after sealing can be suppressed when the average particle diameter is not greater than 60 µm, which is preferable.

Assuming that a total mass of the resin layer is 100% by mass, the filler content included in the resin layer according to the present invention can be 1 to 97% by mass, and the filler content is preferably 5 to 95% by mass or more preferably 10 to 92% by mass. The warp of the resin layer after hardening can be further suppressed when the filler content is not lower than 1% by mass, and an excessive increase in viscosity can be suppressed when the filler content is not greater than 97% by mass, which is preferable.

The film-like wafer mold material having the resin layer consisting of at least one of the respective resins and the filler can suppress warp of a wafer after molding even though a diameter is increased (8 inches, 12 inches, or above) and a film thickness is reduced in a wafer size and can exercise excellent transference performance with respect to the wafer.

### [Arbitrary Components]

Besides, the resin layer according to the present invention can contain an epoxy resin, a polyimide resin, a silicone resin, and others. The respective resins that can be contained in the present invention will now be described hereinafter.

### [Epoxy Resin]

Although the epoxy resin that can be contained in the present invention is not restricted in particular, the epoxy resin can be exemplified by, e.g., a phenol novolac-type epoxy resin, a cresol novolac-type epoxy resin, a bisphenol A type epoxy resin such as diglycidyl bisphenol A, a bisphenol F type epoxy resin such as diglycidyl bisphenol F, a triphenylmethane type epoxy resin such as triphenylolpropane triglycidyl ether, a cyclic aliphatic epoxy resin such as 3,4-epoxycyclo hexylmethyl-3,4-epoxycyclo hexane carboxylate, a glycidyl ester based resin such as diglycidyl phthalate, diglycidyl hexahydro phthalate, and dimethyl glycidyl phthalate, and a glycidyl amine based resin such as tetraglycidyl diamino diphenylmethane, triglycidyl-p-aminophenol, diglycidyl aniline, diglycidyl toluidine, and tetraglycidyl bisamino methylcyclohexane. One type of these resins can be solely used, or two or more types of these resins can be used together. Additionally, a monofunctional epoxy compound containing one epoxy group in one molecule may be added as required.

Various kinds of hardening accelerators may be used for the purpose of facilitating reaction of the epoxy resin or the purpose of facilitating reaction of an epoxy group when a compound having the epoxy group is contained in the resin layer. Examples of the hardening accelerators are an organic phosphine compound such as triphenylphosphine or tricyclohexylphosphine, an amino compound such as trimethyl hexamethylene diamine, diaminodiphenylmethane, 2-(dimethyl aminomethyl)phenol, 2,4,6-tris(dimethyl aminomethyl)phenol, or triethanolamine, and an imidazole compound such as 2-methylimidazole, 2-ethylimidazole, 2-phenylimidazole, or 2-phenyl-4,5-dihydroxy methylimidazole.

### [Polyimide Resin]

Although the polyimide resin that can be contained in the present invention is not restricted in particular, an example of a preferably adopted polyimide resin is a polyimide resin obtained by synthetically making a polyamic acid from dianhydride and a diamine compound and then performing thermal dehydration.

The dianhydride used for synthesis of the polyamic acid is exemplified by 3,3' and 4,4'-diphenylsulphone tetracarboxylic dianhydrides, 3,3' and 4,4'-biphenyl tetracarboxylic dianhydrides, 2,3' and 3,4'-biphenyl tetracarboxylic dianhydrides, 5-(2,5-dioxotetrahydro-3-furanyl)-3-methyl-3-cyclohexene-1,2-dicarboxylic anhydride, 4-(2,5-dioxotetrahydrofuran-3-yl)-1,2,3,4-tetrahydronaphthalene-1,2-dicarboxylic anhydride, 1,2,3,4-butane tetracarboxylic dianhydride, 3,3' and 4,4'-benzophenone tetracarboxylic dianhydrides, 4,4'-hexafluoropropylidene bisphthalate dianhydride, 1,3-tetramethyl disiloxane bisphthalate dianhydride, 4,4'-oxydiphthalic dianhydride, and others.

The diamine compound used for synthesis of the polyamic acid is exemplified by diamine having a phenol group such as 3,3'-diamino-4,4'-dihydroxybiphenyl, 2,2'-diamino-4,4'-dihydroxybiphenyl, 2,2'-bis(4-amino-3-hydroxyphenyl)propane, 2,2-bis(3-amino-4-hydroxyphenyl)propane, 9,9-bis(3-amino-4-hydroxyphenyl)fluorine, 2,2'-methylenebis[6-(4-amino-3,5-dimethylbenzil)-4-methyl]phenol, 3,3'-diamino-4,4'-dihydroxy diphenyle ether, or 2,2-bis(3-amino-4-hydoxyphenyl)hexafluoropropane, 4,4'-diaminobenzanilide, 4,4'-diaminodiphenylether, 3,4'-diaminodiphenylether, 4,4'-diaminodiphenylsulphone, 3,3'-dimethyl-4,4'-diaminobiphenyl, 4,4'-(p-phenylenediisopropylidene)dianiline, 4,4'-(m-phenylenediisopropylidene)dianiline, 1,3-bis(4-aminophenoxy)benzene, 1,4-bis(4-aminophenoxy)benzene, 1,3-bis(3-aminophenoxy)benzene, 2,2-bis[4-(4-aminophenoxy)phenyl]propane, 2,2-bis[4-(4-aminophenoxy)phenyl]hexafluoropropane, bis[4-(4-aminophenoxy)phenyl]sulphone, bis[4-(3-aminophenoxy)phenyl]sulphone, 4,4'-bis(4-aminophenoxy)biphenyl, 9,9-bis(4-aminophenyl)fluorine, and others.

### [Silicone Resin]

Although the silicone resin that can be contained in the present invention is not restricted in particular, a silicone resin obtained by hydrosilylation using a chloroplatinic acid including organohydrogenpolysiloxane and polysiloxane containing an alkenyl group is desirable as an example of preferably adopted silicone resin. At this time, a silicone resin may be added.

### [Organic Solvent]

An organic solvent can be appropriately contained in the resin layer according to the present invention. Although the organic solvent is not restricted in particular, there are, e.g., methyl ethyl ketone, cyclohexanone, cyclopentanone, toluene, and others.

### [Support Film]

The wafer mold material formed in the film-like shape according to the present invention can have a support film. The support film may be a single film or a multilayer film obtained by laminating a plurality of polymer films. As a material, there is a synthetic resin film made of polyethylene, polypropylene, polycarbonate, or polyethylene terephthalate, and polyethylene terephthalate having appropriate flexibility, mechanical strength, and heat resistance is preferable. Further, as such support films, one subjected to various kinds of processing, e.g., a corona treatment or application of a delaminating agent may be adopted. As such support films, commercially available products can be used, and there are, e.g., Cerapeel WZ(RX) and Cerapeel BX8(R) (manufactured by Toray Advanced Film Co., Ltd.), E7302 and E7304 (manufactured by Toyobo Co., Ltd.), Purex G31 and Purex G71T1 (manufactured by Tijin DuPont Films Japan Limited), PET38×1-A3, PET38×1-V8, and PET38×1-X08 (manufactured by Nippa Co., Ltd.).

### [Protective Film]

The wafer mold material formed in a film-like shape according to the present invention can have a protective film. Although the same protective film as the above-described support film can be used, polyethylene terephthalate and polyethylene having appropriate flexibility are preferable. As such materials, commercially available products can be used, polyethylene terephthalate has been already exemplified above, and polyethylene can be exemplified by GF-8 (manufactured by Tamapoly Co., Ltd.) and PE film 0 type (manufactured by Nippa Co., Ltd.).

A thickness of each of the support film and the protective film is preferably 10 to 100 µm and more preferably 25 to 50 µm in terms of stability in manufacture of the wafer mold material and prevention of peculiar winding which is so-called prevention of a curl with respect to a winding core.

### [Wafer Mold Material]

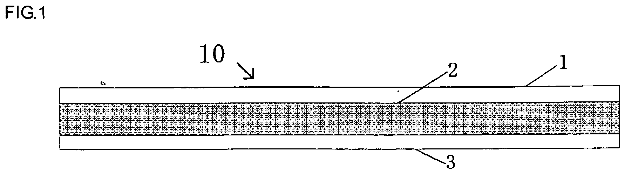

The wafer mold material according to the present invention is a wafer mold material that is for collectively molding a wafer having semiconductor devices on a surface thereof with a resin, has the resin layer containing a filler and at least any one of an acrylic resin, a silicone resin having an epoxy group, an urethane resin, and a polyimide silicone resin and a filler, and is formed into a film-like shape. FIG. 1 shows an embodiment of the wafer mold material according to the present invention. The wafer mold material 10 formed into a film-like shape according to the present invention can have the support film 1 and the protective film 3 besides the resin layer 2. Such a wafer mold material can suppress warp of a wafer after molding and exercise excellent transference performance with respect to the wafer even though a diameter is increased (8 inches, 12 inches, or above) and a film thickness is reduced in a wafer size.

The wafer that is collectively subjected to resin molding using the wafer mold material according to the present invention and has semiconductor devices on a surface thereof may be a wafer having semiconductor device (chips) mounted on a surface thereof or a semiconductor wafer having semiconductor devices fabricated on a surface thereof.

Further, the wafer mold material according to the present invention is formed into a film-like shape. When such film-like wafer mold material is used, when collectively subjecting the wafer having semiconductor devices on a surface thereof to the resin molding, a resin does not have to be flowed in. Therefore, it is possible to eliminate problems, i.e., wire deformation and a short shot that can possibly occur in transfer molding, a difficulty in control over the molding range that can occur in a compression molding method, and optimization of flowability and physical properties of a liquid sealing resin.

The film-like wafer mold material according to the present invention can be manufactured by, e.g., forming the resin layer on a support film and arranging a protective film to be appressed against the upper side of the resin layer.

### [Method for Manufacturing Semiconductor Apparatus]

Furthermore, the present invention provides a method for manufacturing a semiconductor apparatus, comprising at least: a transferring step of transferring the film-like wafer mold material onto a wafer having semiconductor devices on a surface thereof; a heating step of heating the transferred wafer mold material; and a piece forming step of forming each piece by cutting together with the wafer mold material the wafer having the semiconductor devices on the surface having the heated wafer mold material. An embodiment of the method for manufacturing a semiconductor apparatus using the wafer mold material according to the present invention will now be described with reference to FIG. 2.

### [Transferring Step]

The transferring step according to the present invention is a step of transferring the film-like wafer mold material 10 to a wafer 7 having semiconductor devices 4 on a surface thereof (FIGS. 2(A) to (D)). First, the protective film 3 is removed from the film-like wafer mold material 10 to expose the resin layer 2 (FIGS. 2(A) and (B)). The resin layer 2 of the wafer mold material is arranged to be appressed against the wafer 7 having the semiconductor devices 4 on the surface thereof through copper posts 5 and an underfill material 6 (FIG. 2(C)). Then, the wafer mold material (the resin layer 2) is transferred onto the surface of the wafer 7 having the semiconductor devices 4 by delaminating the support film 1 (FIG. 2(D)). Since the wafer mold material 10 can be excellently transferred with respect to the wafer 7 having an increased diameter and a reduced film thickness, a short shot involved by an increase in a mold area can be suppressed. Moreover, at this transferring step, the resin layer 2 of the wafer mold material can be transferred without producing a gap with respect to a shape of each semiconductor device 4 on the wafer 7.

The wafer onto which the wafer mold material is transferred may be a wafer that has semiconductor devices 4 mounted on the surface thereof through the copper post 5 and the underfill 6 and has semiconductor bumps 8 on a back surface or a semiconductor wafer having semiconductor devices fabricated on a surface thereof as shown in FIG.2.

### [Heating Step]

The heating step according to the present invention is a step of heating the transferred wafer mold material (the resin layer 2). The wafer mold material (the resin layer 2) is hardened when heated, thereby collectively molding the wafer 7 having the semiconductor devices 4 on the surface thereof. In the wafer 7 molded with the wafer mold material (the resin layer 2') after hardening, warp is suppressed even though this wafer is a wafer having an increased diameter and a reduced film thickness (FIG. 2(E)).

### [Piece Forming step]

The piece forming step according to the present invention is a step of forming each piece by cutting together with the wafer mold material (the resin layer 2' after hardening) the wafer 7 having the semiconductor devices 4 with the heated wafer mold material (the resin layer 2' after hardening) by using the dicer (not shown). The wafer 7 suppressed from warping even after molding can be excellently formed into pieces. As a result, it is possible to manufacture a semiconductor apparatus 9 formed of a wafer 7' formed as a piece and molded with a hardened resin layer 2" formed as a piece (FIG. 2(F)).

When the method for manufacturing the semiconductor apparatus using the wafer mold material as described above is adopted, the resin layer can be excellently transferred with respect to the wafer even though a diameter is increased (8 inches, 12 inches, or above) and a film thickness is reduced in a wafer size, thereby suppressing the warp of the wafer after molding. Therefore, there can be obtained a semiconductor apparatus manufacturing method that enables manufacture of a semiconductor apparatus without an adsorption failure at the time of carrying a wafer and an inconvenience such as displacement of a cut position in the piece forming step.

### EXAMPLES

The present invention will now be described in more detail based on examples and a comparative example of the wafer mold material and the method for manufacturing a semiconductor apparatus according to the present invention, but the present invention is not restricted thereto.

The wafer mold material according to the present invention will be first described.

### [Example 1]

The following components were put in a planetary centrifugal mixer (manufactured by Thinky Corporation), methyl ethyl ketone was further added and mixed so that overall concentration of these components can be 50% by mass, thereby preparing a resin composition (I) consisting of a silicone resin having an epoxy group and a filler.
SG-P3: an acrylonitrile-based resin having an epoxy group (manufactured by Nagase ChemteX Corporation), 60 parts by mass
KF-102: a silicone resin having an epoxy group (manufactured by Shin-Etsu Chemical Co., Ltd.), 40 parts by mass
RE-310S: a bisphenol A epoxy resin (manufactured by Japan Epoxy Resin Co., Ltd.), 20 parts by mass
4,4'-DDS: 4,4'-diaminodiphenylsulfone (manufactured by Wakayama Seika Kogyo Company Ltd.), 3 parts by mass
2PHZ: 2-phenyl-4,5-dihydroxymethylimidazole (manufactured by Shikoku Chemicals Corporation), 1 part by mass
SE-2050: a silica fine powder (manufactured by Admatechs Co., Ltd.), 15 parts by mass

### [Fabrication of Film-type Wafer Mold Material]

A die coater as a film coater and a polyethylene terephthalate film (a thickness: 38 µm) as a support film were used to coat the support film with the resin composition (I). Then, this material was allowed to pass through for 5 minutes a circulating hot air oven (a length: 4 m) set to 100°C to form a resin layer having a film thickness of 100 µm on the support film. Subsequently, a polyethylene film (a thickness: 50 µm) was used as a protective film, and the protective film was applied to the resin layer using a laminated roll with a pressure of 1 MPa, thereby fabricating a wafer mold material (Example 1).

### [Example 2]

44.4 g (0.1 mol) of a 4,4'-hexafluoropropylidene bisphthalic dianhydride and 350 g of diglyme were put in a flask including an agitator, a thermometer, and a nitrogen substitution device. Then, 5.2 g (0.02 mol) of 2,2-bis(3-amino-4-hydoxyphenyl)propane and 67.2 g (0.08 mol) of diaminosiloxane (both ends of the following general formula (3) represent amino groups, R³ represents a methyl group, and an average of h is 8) were added to the flask while effecting adjustment so that a temperature of a reaction system cannot exceed 50°C. Thereafter, agitation was carried out at a room temperature for 10 hours. Then, a reflux condenser with a moisture receptor was disposed to the flask, then 100 g of toluene was added, a temperature was increased to 150°C, and this temperature was maintained for 6 hours, thereby obtaining a brown solution.

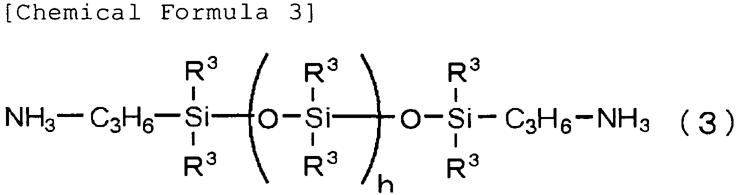

The thus obtained brown solution was cooled to the room temperature (25°C) and then put into methanol, resultant precipitate was filtrated, and a solid matter was dried to obtain a polyimide silicone resin having a repeating unit represented by the following general formula (4). Each of suffixes 0.2 and 0.8 in the following general formula (4) represents a mol ratio in the repeating unit. 100 parts by mass of the polyimide silicon resin, 10 parts by mass of bisphenol A diglycidyl ether, 0.5 part by mass of 2-ethylimidazole, 20 parts by mass of SE-2050 (manufactured by Admatechs Co., Ltd.) as a filler, and cyclopentanone as a solvent were added so that concentration can be 50%, thereby fabricating a resin composition (II) consisting of the polyimide silicone resin and the filler.

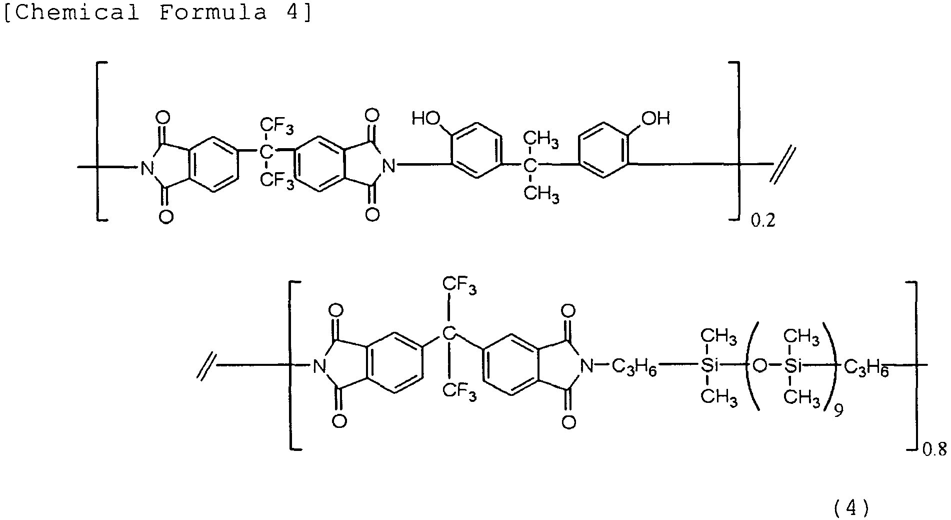

The resin composition (II) was used to fabricate a film-like wafer mold material (Example 2) like Example 1.

### [Example 3]

50 parts of a methylpolysiloxane resin that consists of 1.1 mol of [(CH₃)₃SiO_{1/2}] unit and 1 mol of [SiO_{4/2}] unit and contains 0.07 mol of a hydroxyl group per 100 gram and 50 parts of crude-rubber like dimethylpolysiloxane that has a polymerization degree of 2,000 and is terminated by a hydroxyl group were dissolved in 100 parts of toluene, 0.5 part of ammonia water having concentration of 28% was added to this solution, and agitation was performed at a room temperature for 16 hours to carry out condensation reaction. Then, this reaction solution was heated to 120 to 130°C, condensation water was removed by azeotropic dehydration, the solvent was volatilized 150°C for 30 minutes to obtain a nonvolatile component, and toluene was added so that this nonvolatile component can be 40% by mass, thereby synthetically making a silicone partial condensate-I solution.

100 parts of the silicone partial condensate-I solution, 3 parts of a silicone resin having an epoxy group represented by the following structural formula (5), 2 parts of an organopolysiloxane compound having a silicon atom-bound hydrogen atom represented by the following structural formula (6), 20 parts by mass of SE-2050 (manufactured by Admatechs Co., Ltd.) as a filler, a catalytic amount of a 2-ethylhexanol modified solution of a chloroplatinic acid that provides 10 ppm of a platinum amount, and 0.05 part of 3-methyl-1-butyne-3-ol as a reaction inhibitor were mixed to prepare a resin composition (III) consisting of the silicon resin having the epoxy group and the filler.

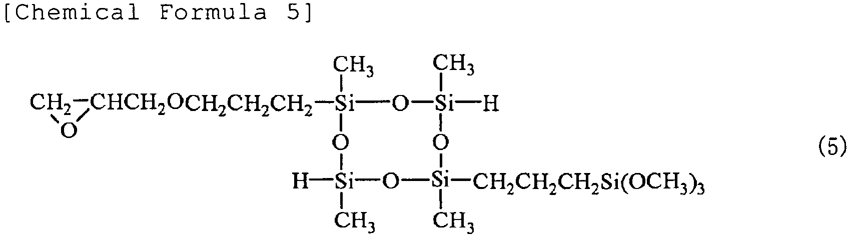

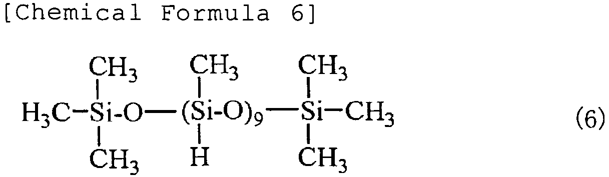

The resin composition (III) was used to fabricate a film-like wafer mold material (Example 3) like Example 1.

### [Example 4]

4 components, i.e., (a) 30 parts of methyl acrylate, (b) 30 parts of acrylonitrile, (c) 40 parts of an acrylic acid, and (d) 50 parts of mono-terminal methacryl modified silicone (X-22-174DX manufactured by Shin-Etsu Chemical Co., Ltd.) were copolymerized in a toluene solution at 60°C using 0.5 part of 2,2'-azobisisobutyronitrile as a radial polymerization initiator, thereby obtaining an acrylic resin.

50 parts of the acrylic resin, 10 parts by mass of bisphenol A diglycidyl ether, 0.5 parts by mass of 2-ethylimidazole, 20 parts by mass of SE-2050 (manufactured by Admatechs Co., Ltd.) as a filler, and cyclopentanone as a solvent were added so that concentration can be 50%, thereby fabricating a resin composition (IV) consisting of the acrylic resin and the filler. The resin composition (IV) was used to fabricate a film-like wafer mold material (Example 4) like Example 1.

### [Example 5]

50 parts of terminal alcohol modified silicone (X-22-170B manufactured by Shin-Etsu Chemical Co., Ltd.) and 50 parts of 2,4-tolylenediisocyanate were reacted to obtain an urethane resin. 50 parts of the urethane resin, 10 parts by mass of bisphenol A diglycidyl ether, 0.5 part by mass of 2-ethylimidazole, 20 parts by mass of SE-2050 (manufactured by Admatechs Co., Ltd.) as a filler, and cyclopentanone as a solvent were added so that concentration can be 50%, thereby fabricating a resin composition (V) consisting of the urethane resin and the filler.

The resin composition (V) was used to fabricate a film-like wafer mold material (Example 5) like Example 1.

### [Comparative Example 1]

300 g of a stylene-butadiene-stylene block copolymer (a trade name: TR2000 manufactured by Japan Synthetic Rubber Corporation, a number average molecular weight: 100000, a stylene/butadiene copolymer ratio [mass]=40/60) and 1500 g of ethyl acetate were put and dissolved in a flask including an agitator and a cooling pipe. Then, 169 g of an ethyl acetate solution having 30% by mass of acetyl hydroperoxide was continuously dropped, and epoxy chemical reaction was carried out based on agitation at 40°C for 3 hours. A reaction liquid was cooled to an ordinary temperature and taken out of the flask, a large amount of methanol was added to carry out precipitation, filtration was effected, and then washing and drying were performed to obtain an epoxidized stylene-butadiene-stylene block copolymer having an epoxy equivalent of 520.

The epoxidized stylene-butadiene-stylene block copolymer was mixed with the following components to prepare a resin composition (VI) having the epoxy resin. The resin composition (VI) was used to fabricate a film-like wafer mold material (Comparative Example 1) like Example 1.
A tetraglycidylphenylmethane type epoxy resin: Epicoat 604 (manufactured by Yuka Shell Epoxy K.K.), 47.1% by mass
A novolac-type phenolic resin: Shonol BRG555 (manufactured by Showa Highpolymer Co., Ltd.), 29.7% by mass
Diaminodisiloxane: TSL9306 (manufactured by Toshiba Silicone Co., Ltd.), 0.9% by mass
An epoxy silane coupling agent: Sila Ace S530 (manufactured by Chisso Corporation), 3% by mass
An imidazole epoxy resin curing agent: Curezol 2E4MZ (manufactured by Shikoku Chemicals Corporation), 0.3% by mass

The thus obtained film-like wafer mold material according to each of Examples 1 to 5 and Comparative Example 1 was transferred onto a wafer having a semiconductor device on a surface thereof (the transferring step), the transferred wafer mold material was heated (the heating step), and the wafer was cut together with the wafer mold material to be formed into each piece (the piece forming step), thereby manufacturing a semiconductor apparatus. Detailed description will now be given hereinafter.

### [Transferring Step]

A silicon wafer that has a thickness of 100 µm and a diameter of 300 mm (12 inches) and has a semiconductor device on a surface thereof was prepared. A protective film was delaminated from each of the six types of wafer mold materials, the inside of a vacuum chamber was set to a vacuum degree of 100 Pa and a resin layer on the support film was closely attached to silicon wafer at 100°C using a vacuum laminator (manufactured by Takatori Corporation, TEAM-300M). After again setting an ordinary pressure, the silicon wafer was cooled to 25°C and taken out from the vacuum laminator, the support film was delaminated, and the wafer mold material was transferred onto the wafer. At this time, transference properties of each wafer mold material were visually evaluated. In the evaluation of the transference properties, successful transference without generation of a gap was evaluated as a good result, and occurrence of a short shot was evaluated as a failure result. Table 1 shows a result.

### [Heating Step]

Subsequently, the wafer having the wafer mold material transferred thereto was heated at 150°C for 1 hour to harden the wafer mold material. After hardening, a storage elastic modulus (MPa) and a wafer warp amount (mm) of each wafer mold material after molding were measured. Table 1 shows a result.

### [Dicing Properties]

After the heating step, the wafer was cut together with the wafer mold material by using a dicer (manufactured by DISCO, DAD361) to be formed into respective pieces. After forming the respective pieces, dicing properties were evaluated. Whether an abnormality such as cracks of a chip (a semiconductor apparatus) is present was visually confirmed in evaluation of dicing properties, an excellent result was obtained when no abnormality was found, and a failure result was obtained when the abnormality was found. Table 1 shows a result.

**[Table 1]**

| Item | Example 1 | Example 2 | Example 3 | Example 4 | Example 5 | Comparative Example 1 |
|---|---|---|---|---|---|---|
| Transference properties | Excellent | Excellent | Excellent | Excellent | Excellent | Excellent |
| Storage elastic modulus (MPa) | 320 | 380 | 240 | 320 | 380 | 1200 |
| Wafer warp amount (mm) | <1 | <1 | <1 | <1 | <1 | 6 |
| Dicing properties | Excellent | Excellent | Excellent | Excellent | Excellent | Failure |

The above table shows that Comparative Example 1 has excellent transference properties, a high storage elastic modulus, a high wafer warp amount, and poor dicing properties. On the other hand, the film obtained by the present invention has excellent transference properties, a low storage elastic modulus, a low wafer warp amount, and excellent dicing properties.

## Claims

1. A method for manufacturing a semiconductor apparatus comprising at least:
a transferring step of transferring a film-like wafer mold material onto a wafer (7) having semiconductor devices (4) on a surface thereof, wherein the wafer mold material has a resin layer (2) containing a filler and at least any one of an annular shape silicone resin having an epoxy group, a silicone resin having an epoxy group which is obtained by hydrosilylation of organohydrogenpolysiloxane and polysiloxane containing an alkenyl group, and a polyimide silicone resin, the resin layer (2) is formed on a support film (1), a protective film (3) is provided on the other side of the resin layer (2), the wafer mold material is formed into a film-like shape, and the filler content included in the resin layer is 1 to 97% by mass assuming that a total mass of the resin layer is 100% by mass;
removing the protective film (3) before the transferring step and removing the support film (1) after the transferring step;
a heating step of heating the transferred wafer mold material and sealing the semiconductor devices (4); and
a piece forming step of cutting the wafer (7) together with the wafer mold material into each piece, the wafer (7) having semiconductor devices (4) on the surface thereof having the heated wafer mold material.

2. The method for manufacturing a semiconductor apparatus according to claim 1, wherein a film thickness of the resin layer is 20 microns to 500 microns.

3. The method for manufacturing a semiconductor apparatus according to claim 1 or 2, wherein the wafer having semiconductor devices on a surface thereof has a diameter of 200 mm or above.

## Patentansprüche

1. Verfahren zur Herstellung einer Halbleitervorrichtung, umfassend mindestens:
einen Übertragungsschritt der Übertragung eines filmähnlichen Waferformmaterials auf einen Wafer (7) mit Halbleiterteilen (4) auf eine Fläche davon, wobei das Waferformmaterial eine Kunststoffschicht (2) hat, enthaltend einen Füllstoff und mindestens einen von einem ringförmigen Silikonkunststoff mit einer Epoxygruppe, einem Silikonkunststoff mit einer Epoxygruppe, der durch Hydrosilylierung von Organowasserstoffpolysiloxan und einem Alkenylgruppe enthaltendem Polysiloxan erhalten wurde, und einem Polyimidsilikonkunststoff, wobei die Kunststoffschicht (2) auf einem Trägerfilm (1) gebildet wird, ein Schutzfilm (3) wird auf der anderen Seite der Kunststoffschicht (2) vorgesehen, das Waferformmaterial wird in eine filmähnliche Gestallt gebracht und der Füllstoffgehalt, der in der Kunststoffschicht enthalten ist, ist 1 bis 97 Massen-%, bezogen auf die Gesamtmasse der Kunststoffschicht mit 100 Massen-%; Entfernen des Schutzfilms (3) vor dem Übertragungsschritt und Entfernen des Trägerfilms (1) nach dem Übertragungsschritt;
einen Erwärmungsschritt der Erwärmung des übertragenen Waferformmaterials und Versiegeln der Halbleiterteile (4), und
einen Teilformschritt des Schneidens des Wafers (7) zusammen mit dem Waferformmaterial, jeweils in ein Teil, wobei der Wafer (7) mit den Halbleiterteilen (4) auf dessen Oberfläche das erwärmte Waferformmaterial hat.

2. Verfahren zur Herstellung einer Halbleitervorrichtung nach Anspruch 1, wobei eine Filmdicke der Kunststoffschicht 20 Mikrometer bis 500 Mikrometer ist.

3. Verfahren zur Herstellung einer Halbleitervorrichtung nach Anspruch 1 oder 2, worin der Wafer mit Halbleiterteilen auf einer Oberfläche davon einen Durchmesser von 200 mm oder darüber hat.

## Revendications

1. Procédé de fabrication d'un appareil à semi-conducteur comprenant au moins :
une étape de transfert consistant à transférer un matériau de moulage de plaquette de type film sur une plaquette (7) comportant des dispositifs semi-conducteurs (4) sur une surface de celle-ci, dans lequel le matériau de moulage de plaquette a une couche de résine (2) contenant une charge et au moins une résine quelconque parmi une résine de silicone de forme annulaire ayant un groupe époxy, une résine de silicone ayant un groupe époxy qui est obtenue par hydrosilylation d'organohydrogénopolysiloxane et de polysiloxane contenant un groupe alcényle, et une résine de silicone polyimide, la couche de résine (2) est formée sur un film support (1), un film de protection (3) est disposé sur l'autre côté de la couche de résine (2), le matériau de moulage de plaquette est façonné en forme de film, et la teneur en charge incluse dans la couche de résine est comprise entre 1 et 97 % en masse, en supposant que la masse totale de la couche de résine représente 100 % en masse ;
à retirer le film protecteur (3) avant l'étape de transfert et à retirer le film de support (1) après l'étape de transfert ;
une étape de chauffage consistant à chauffer le matériau de moulage de plaquette transféré et à sceller les dispositifs semi-conducteurs (4) ; et
une étape de formation de pièce consistant à découper la plaquette (7) conjointement avec le matériau de moulage de plaquette en chaque pièce, la plaquette (7) ayant à sa surface des dispositifs semi-conducteurs (4) comportant le matériau de moulage de plaquette chauffé.

2. Procédé de fabrication d'un appareil à semi-conducteur selon la revendication 1, dans lequel l'épaisseur de film de la couche de résine est comprise entre 20 microns et 500 microns.

3. Procédé de fabrication d'un appareil à semi-conducteur selon la revendication 1 ou 2, dans lequel la plaquette ayant des dispositifs semi-conducteurs sur une surface de celle-ci a un diamètre de 200 mm ou plus.
